# EUROPÄISCHE PATENTSCHRIFT

(11) **EP 1 430 757 B1**
(45) Veröffentlichungstag und Bekanntmachung des Hinweises auf die Patenterteilung: **25.07.2007**
(21) Anmeldenummer: 02730239.7
(22) Anmeldetag: 06.05.2002
(51) Int. Cl.: H05K 3/40, G06K 19/077

(54) **DURCHKONTAKTIERUNG VON FLEXIBLEN LEITERPLATTEN**
THROUGHPLATING OF FLEXIBLE PRINTED BOARDS
CONNEXION TRANSVERSALE DE CARTES DE CIRCUITS IMPRIMES FLEXIBLES

(30) Priorität: 09.05.2001 DE 10122414
(43) Veröffentlichungstag der Anmeldung: 23.06.2004
(73) Patentinhaber: Giesecke & Devrient GmbH, 81677 München (DE)
(72) Erfinder: WELLING, Ando, 84424 Isen (DE); BERGMANN, Matthias, 83569 Vogtareuth (DE); HOPPE, Joachim, 81377 München (DE)
(74) Vertreter: Klunker . Schmitt-Nilson . Hirsch
(86) Internationale Anmeldenummer: PCT/EP2002/004985
(87) Internationale Veröffentlichungsnummer: WO 2002/091811

(56) Entgegenhaltungen:
- DE-A- 2 107 591
- DE-A- 2 241 333
- DE-A- 19 522 338
- GB-A- 2 163 007
- US-A- 2 353 061
- PATENT ABSTRACTS OF JAPAN vol. 017, no. 691 (E-1479), 17. Dezember 1993 (1993-12-17) -& JP 05 235499 A (TAIYO YUDEN CO LTD), 10. September 1993 (1993-09-10)
- PATENT ABSTRACTS OF JAPAN vol. 013, no. 371 (E-807), 17. August 1989 (1989-08-17) & JP 01 125892 A (YAMAZAKI), 18. Mai 1989 (1989-05-18)
- PATENT ABSTRACTS OF JAPAN vol. 1998, no. 02, 30. Januar 1998 (1998-01-30) & JP 09 263079 A (TOYO ALUM KK), 7. Oktober 1997 (1997-10-07)
- PATENT ABSTRACTS OF JAPAN vol. 2000, no. 11, 3. Januar 2001 (2001-01-03) & JP 2000 216537 A (OMRON CORP), 4. August 2000 (2000-08-04)

## Beschreibung

Die Erfindung betrifft die Durchkontaktierung von flexiblen Leiterplatten, welche zum Einbau in Chipkarten geeignet sind. Insbesondere betrifft die Erfindung ein Substrat für eine Karte mit integriertem Schaltkreis (IC-Karte bzw. Chipkarte), welches auf zwei einander gegenüberliegenden Oberflächen elektrisch leitfähige Schichten besitzt, die durch das Substrat hindurch elektrisch leitend miteinander verbunden sind, sowie eine entsprechende Karte und ein Verfahren zur Herstellung eines solchen Substrats.

Ein solches Substrat bzw. solche Leiterplatten werden üblicherweise in IC-Karten (Ausweiskarten, Kreditkarten, Geldkarten, etc.) als Karteninlett integriert und bilden häufig eine separate Schicht des Kartenkörpers. Auf der einen Seite der Leiterplatte kann sich beispielsweise ein durch die leitfähige Schicht gebildeter, integrierter Schaltkreis mit weiteren elektronischen Bauelementen befinden, während die leitfähige Schicht auf der gegenüberliegenden Seite der Leiterplatte beispielsweise als Antennenspule für den kontaktlosen Datenaustausch mit externen Geräten ausgebildet ist, die durch die Leiterplatte hindurch mit dem integrierten Schaltkreis elektrisch leitend verbunden ist. Man spricht in diesem Zusammenhang auch von "Durchkontaktierung" der Leiterplatte.

Das Durchkontaktieren erfolgt in herkömmlicher Weise durch Ausstanzen oder Bohren eines Durchgangslochs, in welches eine Metallhülse zur elektrischen Verbindung der beiden einander gegenüberliegenden, leitfähigen Schichten eingesetzt wird. Solche Durchkontaktierungen sind aufwendig und dementsprechend teuer.

Aus der europäischen Offenlegungsschrift EP-A 0 884 937 ist ein Verfahren zur Durchkontaktierung von ein- oder mehrlagigen Leiterplatten bekannt, bei dem zunächst durchgängige Öffnungen in der Leiterplatte erzeugt werden, welche anschließend mit einer leitfähigen Paste bedruckt werden. Durch Erzeugen von Unterdruck wird die leitfähige Paste in die Kontaktierungslöcher gesaugt. Um eine sichere Durchkontaktierung zu erreichen ist es nötig, in einem ersten Unterdruckschritt die leitfähige Paste in das Durchgangsloch einzusaugen und in einem zweiten Unterdruckschritt die leitfähige Paste zurückzusaugen, um für eine gleichmäßige Verteilung des leitfähigen Materials zu sorgen.

Aus der DE 195 22 338 A1 sowie der JP-A 09263079 ist es bekannt, für die Erzeugung der Durchkontaktierung ein Werkzeug zu verwenden, bei dem die Schneidkante erhitzt werden kann. Das erhitzte Werkzeug wird dabei mit Druck auf die Leiterbahn einer Seite des Substrats aufgesetzt. Dabei erweicht das unter der Leiterbahn liegende Substrat, so daß das Substratmaterial verdrängt wird und die Leiterbahn auf der ersten Seite des Substrats die Leiterbahn auf der zweiten Seite des Substrats berührt, wodurch eine elektrisch leitende Verbindung entsteht.

Aus der japanischen Offenlegungsschrift JP-A 01125892 ist es bekannt zur Durchkontaktierung eine zur Oberfläche senkrechte schnittförmige Durchbrechung zu bilden und einen Teil der Durchbrechung zu verformen, um eine Kontaktierung der gegenüberliegenden Leiterbahnen durch direkten Kontakt und Verlötung zu erreichen. Aus der deutschen Offenlegungsschrift DE-OS 21 07 591 ist es ebenfalls bekannt, eine senkrechte schnittförmige Durchbrechung zur Durchkontaktierung vorzusehen, wobei dort die Kontaktierung der gegenüberliegenden Leiterbahnen ausschließlich durch ein Lotmaterial erfolgt.

Aufgabe der vorliegenden Erfindung ist es, die Herstellung von durchkontaktierten flexiblen Leiterplatten zu vereinfachen.

Diese Aufgabe wird erfindungsgemäß durch ein Substrat für eine IC-Karte und eine entsprechende Karte sowie ein zugehöriges Herstellungsverfahren gemäß den Merkmalen der unabhängigen Ansprüche gelöst. In davon abhängigen Ansprüchen sind vorteilhafte Ausgestaltungen und Weiterbildungen der Erfindung angegeben.

Demnach wird in einfacher Weise mittels eines Schnittwerkzeugs, beispielsweise durch Bandstahlschnitt, Schneidstempel, Messer, Laser o.ä. in der Leiterplatte Schräg zur Oberfläche eine schnittförmige Durchbrechung erzeugt. Vorteilhaft kann durch Druck und Erwärmung das Substratmaterial im Bereich der Durchbrechung verdrängt werden, so daß die sich gegenüberliegenden leitfähigen Schichten sich gegenseitig berühren.

Bei Erzeugung der Durchbrechung sind die Leiterbahnen bereits auf dem Substrat angeordnet.

Die Durchkontaktierung kann in vorteilhafter Weise durch eine mehrfache schnittförmige Durchbrechung oder eine kreuzförmige Durchbrechung gebildet werden.

In einer weiteren vorteilhaften Ausgestaltung der Erfindung ist vorgesehen, dass der Schnitt für die schnittförmige Durchbrechung sehr kurz gewählt wird, so dass lediglich ein punktförmiger Schnitt erzeugt wird. Zur Erzeugung eines derartigen Schnitts werden vorzugsweise Nadeln eingesetzt.

Falls für die Durchkontaktierung notwendig, wird anschließend die Durchbrechung mit einem elektrisch leitfähigen Material gefüllt, wobei es nicht erforderlich ist, dass diese Durchbrechung vollständig gefüllt wird. Es ist ausreichend, wenn eine elektrisch leitende Verbindung zwischen den beiden elektrisch leitfähigen Schichten, welche an den einander gegenüberliegenden Oberflächen der Leiterplatte liegen, hergestellt wird. Das elektrisch leitfähige Material muß also an beide Schichten angrenzen.

Als elektrisch leitfähiges Material kann jedes beliebige Material verwendet werden, wobei allerdings ein elektrisch leitfähiger Flüssigkleber bevorzugt wird, der in einfacher Weise auf die Durchgangsöffnung aufgebracht wird und in die Durchgangsöffnung hineinfließt, ggf. auch unter dem Einfluß von Kapillarkräften aufgrund des vergleichsweise kleinen Öffnungsquerschnitts der Durchgangsöffnung.

Das elektrisch leitfähige Material kann in vorteilhafter Weise mittels einer Dosiernadel oder durch Sieb- bzw. Tintenstrahldruck ein- oder beidseitig aufgebracht werden.

Zum Aufbringen des elektrisch leitenden Materials, insbesondere leitfähigen Flüssigklebers, wird vorzugsweise eine Dosiernadel verwendet, die hohl ist, so dass der Spitze der Dosiernadel eine definierte Menge des Materials durch die Dosiernadel hindurch zugeführt werden kann.

Gemäß einer ersten bevorzugten Ausführungsform wird an der Spitze der Dosiernadel zunächst eine definierte Menge des Materials, beispielsweise als an der Spitze hängender Materialtropfen, vorbereitet ("Vordosierung"), bevor die Dosiernadel an die Durchbrechung herangeführt wird.

Gemäß einer zweiten bevorzugten Ausführungsform wird die Dosiernadel erst an die Durchbrechung herangeführt ("Nachdosierung") und dann das Material durch die Dosiernadel hindurch in die Durchbrechung hineingespritzt. Vordosierung und Nachdosierung können auch miteinander kombiniert werden.

Für die Verwendung von Silberleitpaste oder Carbonfarbe als leitfähiges Material für die Durchkontaktierung eignet sich Siebdruck besonders.

Bei Verwendung von elektrisch leitfähiger Tinte wird bevorzugt die Tintenstrahldrucktechnik eingesetzt. Diese Technik hat aufgrund des guten Fließverhaltens von leitfähiger Tinte besondere Vorteile für die Durchkontaktierung mit schnittförmigen Durchbrechungen, da sie diese leichter durchdringen kann als zähflüssige Materialien.

Das erfindungsgemäße Verfahren und die so hergestellten Substrate bzw. Leiterplatten sowie IC-Karten besitzen gegenüber herkömmlichen Durchkontaktierungen den Vorteil, dass sowohl das Erzeugen des Durchgangslochs als auch die Kontaktherstellung mit einfachsten Mitteln sehr preiswert zu realisieren sind. Es bedarf keiner aufwendigen Vorrichtungen oder teuren Hilfsstoffe, und der Dosiervorgang zur Einbringung des elektrisch leitfähigen Materials ist sehr einfach beherrschbar.

Da die schnittförmige Durchbrechung schräg zur Oberfläche des Substrats erfolgt, kann auf die Verwendung von weiterem leitfähigen Material verzichtet werden. In diesem Fall reicht es aus, die durch den schrägen Schnitt entstehenden Laschen aneinander vorbeizudrücken, so daß sich die auf dem Substrat gegenüberliegenden Leiterbahnen berühren, d.h. die Leiterbahn auf der Oberseite des Substrats berührt die Leiterbahn der Unterseite des Substrats. Durch den Einbau in die Karte, welcher üblicherweise durch Laminieren erfolgt, wird die Verbindung stabilisiert.

Alternativ kann für die Erzeugung der Durchkontaktierung ein Werkzeug verwendet werden, bei dem die Schneidspitze/-kante erhitzt werden kann. Das erhitzte Werkzeug wird dabei mit Druck auf die Leiterbahn einer Seite des Substrats aufgesetzt. Dabei erweicht das unter der Leiterbahn liegende Substrat, so daß das Substratmaterial verdrängt wird und die Leiterbahn auf der ersten Seite des Substrats die Leiterbahn auf der zweiten Seite des Substrats berührt, wodurch eine elektrisch leitende Verbindung entsteht.

Nachfolgend wird die Erfindung anhand der begleitenden Zeichnungen beispielhaft beschrieben- Darin zeigen:
- Fig.1a und b: die Vorderseite und die Rückseite eines Substrats, und
- Fig. 2a bis 2e: verschiedene Formen von Durchkontaktierungen.

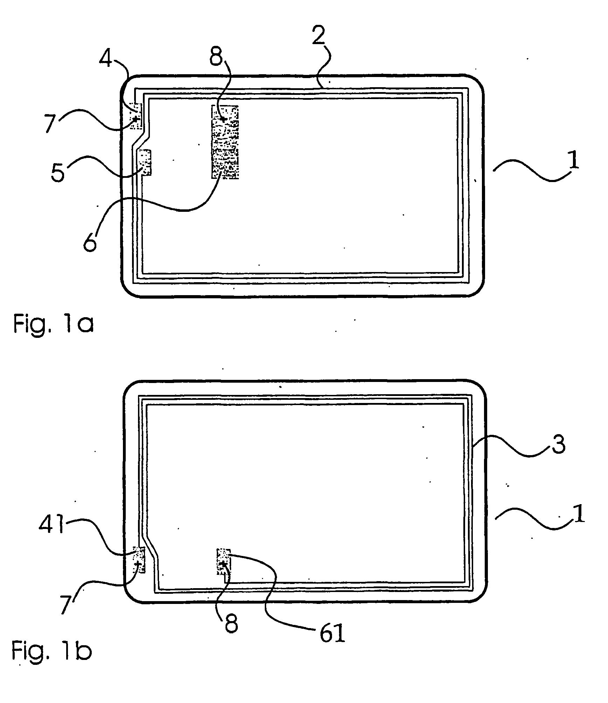

Die Fig. 1a zeigt die Vorderseite eines Substrats 1, welches zum Einbau in einen Kartenkörper geeignet ist. Auf dieser Seite des Substrats ist eine leitfähige Schicht 2 in Form einer Spule für den kontaktlosen Daten- und Energieaustausch mit einem externen Gerät dargestellt. Die auf dieser Seite des Substrats 1 angeordnete Spule weist die Kontanktflächen 4 und 5 auf, wobei die Kontaktfläche 5 zur Kontaktierung mit dem Modul vorgesehen ist. Eine weitere Kontaktierung der Spule mit dem integrierten Schaltkreis erfolgt durch die Kontaktfläche 6, welche mittels der Durchkontaktierung 8 mit der zweiten elektrisch leitfähigen Schicht 3 in Form einer zweiten Spule auf der Rückseite des Substrats 1 verbunden ist (Fig. 1b).

Die Durchkontaktierung erfolgt in Fig.1 mit einer kreuzförmigen Durchbrechung, welche mit elektrisch leitfähigem Material gefüllt ist Mit dieser Durchbrechung wird ein elektrischer Kontakt zur Spule 3 auf der Rückseite des Substrats hergestellt. Eine weitere Durchkontaktierung 7 derselben Art verbindet die Kontaktfläche 4 mit der Spule 3. Zur Durchkontaktierung sind, wie aus Fig. 1b zu erkennen ist, die Kontaktflächen 61 und 41 vorgesehen.

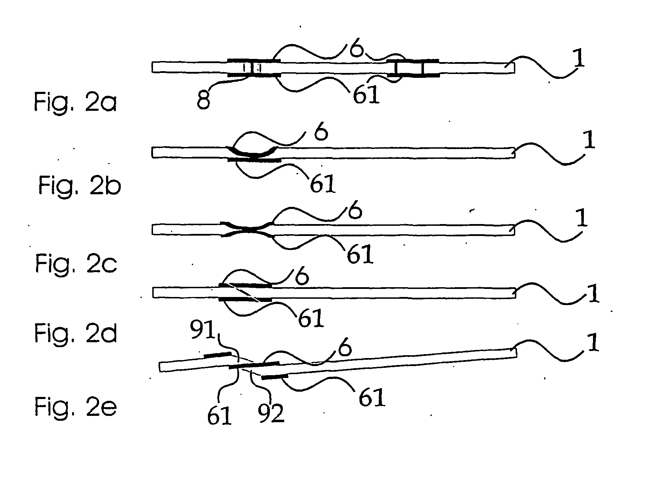

Die Durchkontaktierung 8 ist in Fig. 2a im Querschnitt gezeigt, wobei die erste Schnittlinie schwarz dargestellt ist und die senkrecht dazu verlaufende zweite Schnittlinie grau unterlegt ist. Die Fig. 2a zeigt weiterhin eine zweite Art der Durchbrechung, die mehrfache, im vorliegenden Fall eine zweifache Durchbrechung.

Die in Fig. 2a gezeigten Durchbrechungen werden mit leitfähigem Material gefüllt, welches beispielsweise mit einer Dosiernadel ein- oder zweiseitig aufgebracht wird. Alternativ können je nach Art des verwendeten leitfähigen Materials auch Siebdruck- oder Tintenstrahldruckverfahren verwendet werden.

Das Durchdringen des elektrisch leitfähigen Materials kann erleichtert werden, wenn gleichzeitig mit oder unmittelbar nach dem Aufbringen die durchzukontaktierende Stelle bzw. der Bereich leicht durchgebogen wird, um eine Öffnung zu schaffen bzw. zu vergrößern.

Die Fig. 2b zeigt ein Beispiel bei dem mittels eines Werkzeugs, dessen Spitze bzw. Kante vorzugsweise erhitzt wird, Druck auf die eine Kontaktfläche 6 ausgeübt wird. Durch das Erhitzen und den Druck wird die Kontaktfläche 6 an die Kontaktfläche 61 gedrückt und die leitende Verbindung hergestellt. Das in diesem Bereich befindliche Substratmaterial wird durch die Hitze zumindest zähfließend und kann so ohne weiteres verdrängt werden.

Die Fig. 2c zeigt ein Beispiel bei dem der Druck und die Erhitzung durch das Werkzeug von beiden Seiten ausgeübt wird.

Als Werkzeug werden in vorteilhafter Weise eine Lötkolbenspitze oder ein Ultraschallkopf verwendet. Diese Werkzeuge können ohne großen Aufwand an verschiedene Anforderungen angepaßt werden.

In Fig. 2d ist eine Ausführungsform gezeigt, bei der der Schnitt durch das Substrat und die elektrisch leitenden Kontaktflächen der Spule schräg zur Oberfläche erfolgt. Bei diesem Schnitt kann analog zu den Beispielen nach Fig. 1a leitfähiges Material verwendet werden, um den elektrischen Kontakt zwischen den gegenüberliegenden Kontaktflächen 6 und 61 herzustellen.

Alternativ können bei dieser Ausführungsform des Schnitts die beiden Laschen 91 und 92 durch Druck gegeneinander vorbeigedrückt werden (Fig. 2e), so dass sich die gegenüberliegenden Kontaktflächen berühren und somit den elektrischen Kontakt herstellen. Ein Teil der Kontaktfläche 6, welche auf der Substratoberseite angeordnet ist, berührt somit einen Teil der Kontaktfläche 61, welche auf der Substratunterseite angeordnet ist.

Um die Schnitte gemäß den Fig. 2a, d und e zu erzeugen, werden in vorteilhafter Weise Schneidstempel oder Messer verwendet. Gute Ergebnisse können auch bei Verwendung eines Lasers oder ähnlicher Werkzeuge erzielt werden.

## Patentansprüche

1. Substrat (1) für eine Karte mit integriertem Schaltkreis, wobei das Substrat auf zwei einander gegenüberliegenden Oberflächen mit elektrisch leitfähigem Material beschichtet ist und wobei diese beiden elektrisch leitfähigen Schichten durch das Substrat hindurch elektrisch miteinander verbunden sind, **gekennzeichnet durch** ein **durch** das Substrat und die beiden elektrisch leitfähigen Schichten (2, 3) hindurchgehende, schräg zur Oberfläche verlaufende schnittförmige Durchbrechung.

2. Substrat nach Anspruch 1, **dadurch gekennzeichnet, dass** eine Durchkontaktierung durch eine mehrfache schnittförmige Durchbrechung gebildet ist, welche mit elektrisch leitfähigem Material gefüllt ist.

3. Substrat nach Anspruch 1, **dadurch gekennzeichnet, dass** eine Durchkontaktierung durch eine kreuzförmige Durchbrechung gebildet ist, welche mit elektrisch leitfähigem Material gefüllt ist.

4. Substrat nach Anspruch 3, **dadurch gekennzeichnet, dass** der Querschnitt der Durchbrechung punktförmig ausgeführt ist.

5. Substrat nach Anspruch 3 oder 4, **dadurch gekennzeichnet, dass** die durch die schnittförmige Durchbrechung erzeugten Laschen aneinander vorbeigedrückt sind, so dass die Leiterbahn der Substratoberseite die Leiterbahn der Substratunterseite berührt.

6. Karte mit integriertem Schaltkreis umfassend ein Substrat (1) nach einem der Ansprüche 1 bis 5.

7. Karte nach Anspruch 6, **dadurch gekennzeichnet, dass** das Substrat (1) eine Schicht des Kartenkörpers bildet.

8. Verfahren zur Herstellung eines Substrats (1) nach einem der Ansprüche 1 bis 6, umfassend die Schritte:
- zur Verfügungstellen des Substrats (1) oder eines Substrats (1) mit zwei elektrisch leitfähigen Schichten (2, 3) auf einander gegenüberliegenden Oberflächen des Substrats,
- Durchschneiden des Substrats (1) und der beiden elektrisch leitfähigen Schichten (2, 3) mittels eines Schnittwerkzeugs (10) schräg zur Oberfläche, so dass nach dem Entfernen des Werkzeugs eine schräg zur Oberfläche verlaufende schnittförmige Durchbrechung zurückbleibt.

9. Verfahren zur Herstellung eines Substrats (1) nach Anspruch 8, **dadurch gekennzeichnet, dass** die Durchbrechung mit einem elektrisch leitfähigen Material derart gefüllt wird, das an die beiden elektrisch leitfähigen Schichten (2, 3) angrenzt und diese elektrisch leitend miteinander verbindet.

10. Verfahren nach Anspruch 9, **dadurch gekennzeichnet, dass** als elektrisch leitfähiges Material zum Füllen der Durchbrechung ein flüssiger Leitkleber verwendet wird.

11. Verfahren nach Anspruch 10, **dadurch gekennzeichnet, dass** das elektrisch leitfähige Material mittels Dosiernadeln, Siebdruck oder Tintenstrahldruck aufgebracht wird.

12. Verfahren nach einem der Ansprüche 9 bis 11, **dadurch gekennzeichnet, dass** das für die Durchkontaktierung verwendete elektrisch leitfähige Material beidseitig im Bereich der zu erzeugenden Durchkontaktierung aufgebracht wird.

## Claims

1. A substrate (1) for a card with an integrated circuit, the substrate being coated on two opposing surfaces with electrically conductive material and said two electrically conductive layers being electrically interconnected through the substrate, **characterized by** a cut-shaped passage going through the substrate and the two electrically conductive layers (2, 3) and extending obliquely to the surface.

2. The substrate according to claim 1, **characterized in that** a throughplating is formed by a multiple cut-shaped passage filled with electrically conductive material.

3. The substrate according to claim 1, **characterized in that** a throughplating is formed by a cross-shaped passage filled with electrically conductive material.

4. The substrate according to claim 3, **characterized in that** the cross section of the passage is point-shaped.

5. The substrate according to claim 3 or 4, **characterized in that** the tabs produced by the cut-shaped passage are urged past each other so that the conductive path on the top of the substrate touches the conductive path on the bottom of the substrate.

6. A card with an integrated circuit comprising a substrate (1) according to any of claims 1 to 5.

7. The card according to claim 6, **characterized in that** the substrate (1) forms a layer of the card body.

8. A method for producing a substrate (1) according to any of claims 1 to 6, comprising the steps of:
- providing the substrate (1) or a substrate (1) with two electrically conductive layers (2, 3) on opposing surfaces of the substrate,
- cutting through the substrate (1) and the two electrically conductive layers (2, 3) obliquely to the surface by means of a cutting tool (10) so that a cut-shaped passage extending obliquely to the surface remains after removal of the tool.

9. The method for producing a substrate (1) according to claim 8, **characterized in that** the passage is filled in such a way with an electrically conductive material that adjoins the two electrically conductive layers (2, 3) and electrically interconnects them.

10. The method according to claim 9, **characterized in that** a liquid conductive adhesive is used as the electrically conductive material for filling the passage.

11. The method according to claim 10 , **characterized in that** the electrically conductive material is applied by metering needles, screen printing or ink-jet printing.

12. The method according to any of claims 9 to 11, **characterized in that** the electrically conductive material used for the throughplating is applied on both sides in the area of the throughplating to be produced.

## Revendications

1. Substrat (1) pour une carte à circuit intégré, le substrat étant revêtu, sur deux surfaces opposées l'une à l'autre, d'un matériau conducteur de l'électricité et ces deux couches conductrices de l'électricité étant reliées ensemble électriquement à travers le substrat, **caractérisé par** une traversée en forme de découpe, s'étendant obliquement par rapport à la surface, passant à travers le substrat et les deux couches (2, 3) conductrices de l'électricité.

2. Substrat selon la revendication 1, **caractérisé en ce qu'**une connexion transversale est formée par une traversée en forme de découpes multiples, remplie d'un matériau conducteur de l'électricité.

3. Substrat selon la revendication 1, **caractérisé en ce qu**'une connexion transversale est formée par une traversée en forme de croix, remplie d'un matériau conducteur de l'électricité.

4. Substrat selon la revendication 3, **caractérisé en ce que** la section transversale de la traversée est conformée en points.

5. Substrat selon la revendication 3 ou 4, **caractérisé en ce que** les pattes produites par la traversée en forme de découpe sont pressées en étant passées les unes sur les autres, de manière que la piste conductrice de la face supérieure de substrat soit en contact avec la piste conductrice de la face inférieure de substrat.

6. Carte à circuit intégré comprenant un substrat (1) selon l'une des revendications 1 à 5.

7. Carte selon la revendication 6, **caractérisé en ce que** le substrat (1) forme une couche du corps de carte.

8. Procédé de fabrication d'un substrat (1) selon l'une des revendications 1 à 6, comprenant les étapes consistant à:
- mettre à disposition le substrat (1) ou un substrat (1), ayant deux couches (2, 3) conductrices de l'électricité sur des surfaces opposées l'une à l'autre du substrat,
- effectuer le découpage traversant du substrat (1) et des deux couches (2, 3) conductrices de l'électricité, à l'aide d'un outil de coupe (10), obliquement par rapport à la surface, de manière qu'après enlèvement de l'outil, subsiste une traversée en forme de coupe, s'étendant obliquement par rapport à la surface.

9. Procédé de fabrication d'un substrat (1) selon la revendication 8, **caractérisé en ce que** la traversée est remplie d'un matériau conducteur de l'électricité, limitrophe aux deux couches (2, 3) conductrices de l'électricité, et les reliant ensemble de façon conductrice de l'électricité.

10. Procédé selon la revendication 9, **caractérisé en ce qu'**on utilise comme matériau conducteur de l'électricité, pour remplir la traversée, un adhésif conducteur liquide.

11. Procédé selon la revendication 10, **caractérisé en ce que** le matériau conducteur de l'électricité est appliqué à l'aide de seringues doseuses, par impression sérigraphique, ou par impression par jet d'encre.

12. Procédé selon l'une des revendications 9 à 11, **caractérisé en ce que** le matériau conducteur de l'électricité, utilisé pour la connexion transversale, est appliqué sur les deux faces dans la zone de la connexion transversale à produire.
